# EUROPEAN PATENT APPLICATION

(11) **EP 4 525 152 A1**
(43) Date of publication of application: **19.03.2025**
(21) Application number: 24199602.4
(22) Date of filing: 10.09.2024
(51) Int. Cl.: H01M 50/209, H01M 50/507, H01M 50/516, H01M 50/519, H01M 50/522

(54) **RECHARGEABLE BATTERY MODULE**

(30) Priority: 18.09.2023 KR 20230124187
(71) Applicant: Samsung SDI Co., Ltd, Gyeonggi-do 17084 (KR)
(72) Inventor: KWON, Young-Hwan, 17084 Yongin-si (KR); LEE, Hyeok, 17084 Yongin-si (KR)
(74) Representative: Marks & Clerk LLP

(57) **Abstract**

A rechargeable battery module may include a plurality of battery cells stacked in a first direction, a busbar holder configured to at least partially cover the battery cells while exposing the electrode terminals of the battery cells upwardly, a busbar connecting the electrode terminals of the battery cells exposed through a busbar support portion of the busbar holder, a flexible printed circuit (FPC) forming an exposure hole in a vertical direction perpendicular to the first direction, the flexible printed circuit being disposed on and electrically connected to the busbar to expose a copper thin film portion of the flexible printed circuit in a direction toward the busbar, and a metal tab inserted into an interior of the flexible printed circuit, the metal tab being electrically connected to a surface of the copper thin film portion, and exposed outwardly through the exposure hole.

## Description

### FIELD OF THE INVENTION

The present invention relates to a rechargeable battery module in which a metal tab for electrical connection to a busbar is built into a flexible printed circuit (FPC).

### BACKGROUND OF THE INVENTION

### Description of the Related Art

A rechargeable battery can be repeatedly charged and discharged, unlike a primary battery. Small-capacity rechargeable batteries are used in small portable electronic devices such as mobile phones, notebook computers, and camcorders.

High-capacity and high-density rechargeable batteries are used for power or energy storage for driving motors in hybrid vehicles and electric vehicles. The rechargeable battery may be used in a rechargeable battery module including a plurality of battery cells connected in series and/or parallel to drive a motor of, for example, a hybrid vehicle that requires relatively high energy density.

For example, a rechargeable battery module connects a flexible printed circuit (FPC) and a busbar made of aluminum or copper to measure cell voltage, e.g., by using an intermediate medium comprising a nickel tab.

By using the nickel tab as an intermediate medium, a first end of the nickel tab is connected to the flexible printed circuit by soldering, and a second end of the nickel tab is connected to the busbar by laser welding. The method using nickel tabs increases raw material cost and deteriorates cost competitivity in rechargeable battery modules.

### SUMMARY OF THE INVENTION

The present disclosure provides a rechargeable battery module that reduces manufacturing cost and processing time by having a metal tab built in a flexible printed circuit (FPC).

A rechargeable battery module may include a plurality of battery cells stacked in a first direction, a busbar holder configured to expose electrode terminals of the battery cells upward and at least partially cover the battery cells, a busbar connecting the electrode terminals of the battery cells exposed through a busbar support portion of the busbar holder, a flexible printed circuit (FPC) forming an exposure hole in a vertical direction perpendicular to the first direction, the flexible printed circuit being disposed on and electrically connected to the busbar to expose a copper thin film portion of the flexible printed circuit in a direction toward the busbar, and a metal tab inserted into an interior of the flexible printed circuit, the metal tab being electrically connected to a surface of the copper thin film portion, and exposed outwardly through the exposure hole.

The copper thin film portion may be formed in a thickness of 1 oz.

The metal tab may be formed in a thickness of 0.1-0.2 mm.

The flexible printed circuit may include a signal line configured to transmit a sensing signal, a connection line configured to connect the copper thin film portion to the signal line, and a covering portion configured to at least partially cover the signal line, the copper thin film portion and the connection line; to expose a portion of the copper thin film portion on a first side of the copper thin film portion; and to expose a portion of the metal tab on a second side of the metal tab.

The covering portion may include a first covering layer forming a first exposure hole that exposes the copper thin film portion in the direction toward the busbar, and a second covering layer, wherein the copper thin film portion and the metal tab are interposed between the first covering layer and the second covering layer, and the second covering layer forming a second exposure hole exposing a portion of the metal tab.

An adhesive may be applied on an inner surface of each of the first covering layer and the second covering layer, so as to fix the copper thin film portion and the metal tab to a position between the first and second covering layers.

A rechargeable battery module may include a slot hole configured to at least partially surround an outer perimeter of the copper thin film portion and to penetrate the covering portion, the slot hole having a first end and a second end, the first and second ends of the slot hole being disposed at respective sides of the connection line in a width direction.

The signal line may be formed on a first side of the flexible printed circuit in width direction, and may extend in a length direction of the flexible printed circuit.

The copper thin film portion may be inserted between the first covering layer and the second covering layer, and a portion of a surface on a first side of the copper thin film portion may be exposed through the first exposure hole and a portion of a surface on a second side of the copper thin film portion may face the second exposure hole and may be electrically connected to the metal tab.

The metal tab, the copper thin film portion, and the busbar may be electrically connected to each other by welding when in surface contact with each other.

The copper thin film portion may be inserted in a first area sized between the first covering layer and the second covering layer, and the metal tab may have a first surface electrically connected to the surface on the second side of the copper thin film portion and a second surface of which a portion is exposed by the second exposure hole of the second covering layer.

The second covering layer may comprise a stepped portion having an edge portion of the metal tab located thereon and the stepped portion may be formed on an inner surface of the second exposure hole of the second covering layer.

According to some embodiments, there is provided a method of manufacturing a rechargeable battery module, the method comprising: stacking a plurality of battery cells in a first direction; providing a busbar holder such that the busbar holder at least partially covers the battery cells while exposing electrode terminals of the battery cells; connecting the electrode terminals of the battery cells via a busbar, the electrode terminals of the battery cells being exposed through a busbar support portion of the busbar holder; providing a flexible printed circuit (FPC) on and electrically connecting the flexible printed circuit to the busbar, the flexible printed circuit forming an exposure hole in a vertical direction perpendicular to the first direction and exposing a copper thin film portion of the flexible printed circuit in a direction toward the busbar; and inserting a metal tab into an interior of the flexible printed circuit and electrically connecting the metal tab to a surface of the copper thin film portion, the metal tab being exposed outwardly through the exposure hole of the flexible printed circuit.

In some embodiments, the copper thin film portion has a thickness of 1 oz.

In some embodiments, the metal tab has a thickness of 0.1-0.2 mm.

In some embodiments, the flexible printed circuit comprises: a signal line configured to transmit a sensing signal; a connection line configured to connect the copper thin film portion to the signal line; and a covering portion configured to: at least partially cover the signal line, the copper thin film portion, and the connection line; expose a portion of the copper thin film portion on a first side of the copper thin film portion; and expose a portion of the metal tab on a second side of the metal tab.

In some embodiments, the covering portion comprises: a first covering layer forming a first exposure hole that exposes the copper thin film portion in the direction toward the busbar; and a second covering layer, wherein the copper thin film portion and the metal tab are interposed between the first covering layer and the second covering layer, and the second covering layer forming a second exposure hole exposing a portion of the metal tab.

In some embodiments, the method further comprises applying an adhesive on an inner surface of each of the first covering layer and the second covering layer to fix the copper thin film portion and the metal tab to respective positions between the first and second covering layers.

In some embodiments, the method further comprises forming a slot hole at least partially surrounding a perimeter of the copper thin film portion and penetrating the covering portion, the slot hole having a first end and a second end, the first and second ends of the slot hole being disposed at respective sides of the connection line in a width direction.

According to some embodiments, there is provided a system for use in a rechargeable battery module, the system comprising: a busbar; and a flexible printed circuit (FPC) disposed on and electrically connected to the busbar, the flexible printed circuit comprising: an exposure hole formed in the flexible printed circuit in a vertical direction; a copper thin film portion, the copper thin film portion being exposed in a direction towards the busbar; and a metal tab inserted into an interior of the flexible printed circuit, the metal tab being electrically connected to a surface of the copper thin film portion and exposed outwardly through the exposure hole.

According to an embodiment, by inserting a metal tab into an interior of a covering portion of a flexible printed circuit, it may be electrically connected to a busbar by sandwich welding in a state of being disposed on a surface of a copper thin film portion. Therefore, according to the present embodiment, during the process of manufacturing a flexible printed circuit, conventional soldering process for connecting a metal tab may not be needed, thereby enabling streamlining of the manufacturing process and reduction of manufacturing cost.

The rechargeable battery module may be a rechargeable battery module as defined above.

At least some of the above and other features of the invention are set out in the claims.

### BRIEF DESCRIPTION OF THE DRAWINGS

FIG. 1 is an exploded perspective view schematically illustrating a rechargeable battery module according to a first embodiment.
FIG. 2 is a perspective view schematically illustrating a flexible printed circuit installed in a busbar holder of FIG. 1.
FIG. 3 is a top plan view schematically illustrating a flexible printed circuit according to a first embodiment.
FIG. 4 is a top plan view schematically illustrating a copper thin film portion and a metal tab inserted into the flexible printed circuit of FIG. 3.
FIG. 5 is an exploded perspective view schematically illustrating a flexible printed circuit that mounts a copper thin film portion and a metal tab, the flexible printed circuit being laser-welded to a busbar.
FIG. 6 is a cross-sectional view taken along line A-A of the flexible printed circuit of FIG. 4 where a copper thin film portion and a metal tab are inserted in the flexible printed circuit, the flexible printed circuit being laser-welded to a busbar.
FIG. 7 is a drawing schematically illustrating a flexible printed circuit according to a second embodiment.
FIG. 8 is a top plan view schematically illustrating the flexible printed circuit of FIG. 7 in which a copper thin film portion and a metal tab are inserted therein and electrically connected thereto.

### DETAILED DESCRIPTION

Hereinafter, the present invention will be described more fully with reference to the accompanying drawings, in which embodiments of the invention are shown. As those skilled in the art would realize, the described embodiments may be modified in various different ways, all without departing from the scope of the present invention. The drawings and description are to be regarded as illustrative in nature and not restrictive. Like reference numerals designate like elements throughout the specification.

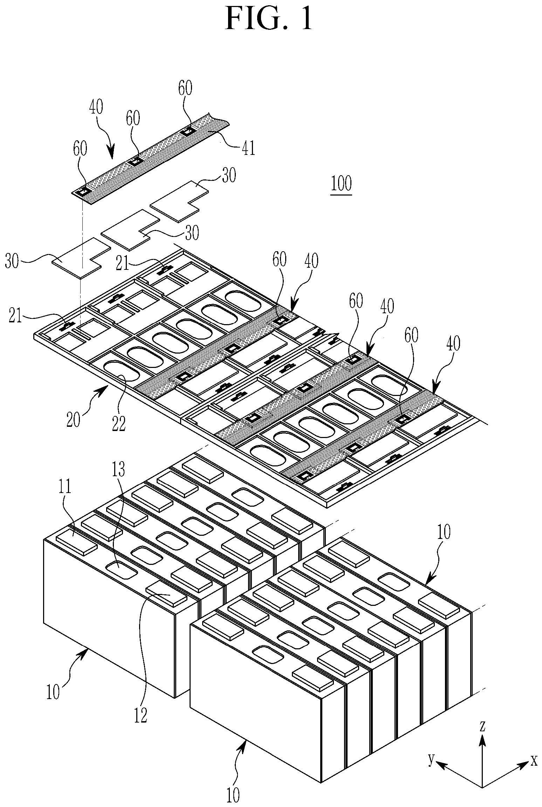

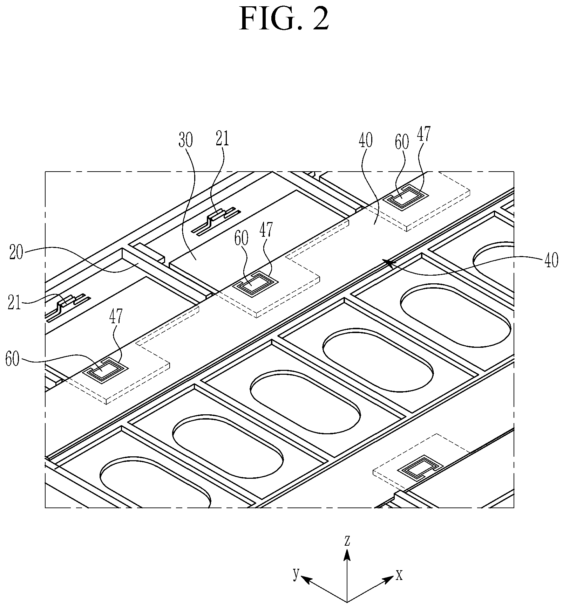

FIG. 1 is an exploded perspective view schematically illustrating a rechargeable battery module according to a first embodiment. FIG. 2 is a perspective view schematically illustrating a flexible printed circuit installed in a busbar holder of FIG. 1.

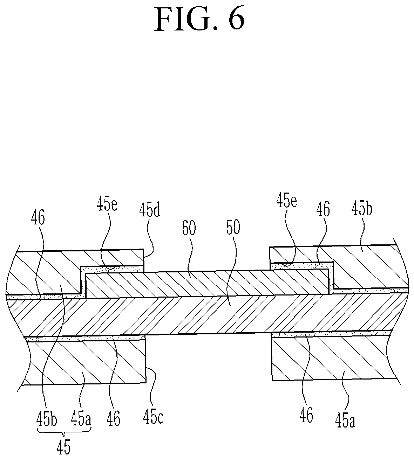

As shown in FIG. 1 and FIG. 2, a rechargeable battery module 100 according to an embodiment includes a plurality of battery cells 10 stacked in a first direction, a busbar holder 20 configured to expose electrode terminals 11 and 12 of the battery cells 10 upward and at least partially cover the battery cells 10, a busbar 30 connecting the electrode terminals 11 and 12 exposed through a busbar support portion 21 of the busbar holder 20, a flexible printed circuit (FPC) 40 forming exposure holes 45c and 45d (referred to in additional detail in FIG. 6) in a vertical direction (z-axis direction) perpendicular to the first direction and disposed on the busbar 30 to expose a copper thin film portion 50 in a direction toward the busbar 30, and a metal tab 60 inserted into an interior of the flexible printed circuit 40 and electrically connected to a surface of the copper thin film portion 50.

The rechargeable battery module 100 of the present embodiment may include frames (not shown) of various structures that interiorly accommodate the plurality of battery cells 10. Hereinafter, detailed description on the configuration of the frame accommodating a battery cell 10 will be omitted, and the major configuration of the present embodiment will be described.

The plurality of battery cells 10 may be formed as a rechargeable battery, and may be stacked in the first direction (e.g., x-axis). A pair of end plates may be disposed at both ends in the first direction of the stacked battery cells 10 and may support the battery cells 10 in the first direction (x-axis direction).

A pair of side plates may be disposed on both sides of battery cells 10 in a second direction (y-axis direction) crossing (e.g., perpendicular to) the first direction, and connected to the pair of end plates, to support the battery cells 10 in the second direction (y-axis direction).

The busbar holder 20 may include the busbar support portion 21 for connection and insulation of the electrode terminals 11 and 12 of the battery cells 10 and a vent portion 22 for discharging a vent gas of the battery cells 10.

The busbar support portion 21 may expose the electrode terminals 11 and 12 in a third direction (z-axis direction) and cover an upper portion of the battery cells 10. Here, the third direction refers to a direction crossing (e.g., perpendicular to) the first direction (x-axis direction) and the second direction (y-axis direction).

The vent portion 22 corresponds to a vent 13 of the battery cells 10, and when the vent 13 is opened, may discharge the opening pressure and discharge of the battery cell 10 to the outside of the busbar holder 20.

The busbar 30 may be welded to the electrode terminals 11 and 12 exposed through the busbar support portion 21 in the third direction such that the electrode terminals 11 and 12 may be electrically and mechanically connected.

That is, the busbar 30 may connect the electrode terminals 11 and 12 of the battery cells 10 which neighbor each other in the first direction (e.g., the x-axis direction) in parallel or which neighbor each other in series.

Busbar support portions 21 corresponding to the electrode terminals 11 and 12 in the second direction (y-axis direction) may be disposed at both sides of the battery module 100, and the vent portion 22 corresponding to the vent 13 provided between the electrode terminals 11 and 12 in the second direction (y-axis direction) may be disposed between the busbar support portions 21.

The flexible printed circuit 40 may be disposed on the busbar 30, the flexible printed circuit 40 having the copper thin film portion 50 and the metal tab 60 exposed in the third direction (z-axis direction) and being interiorly positioned within the flexible printed circuit 40.

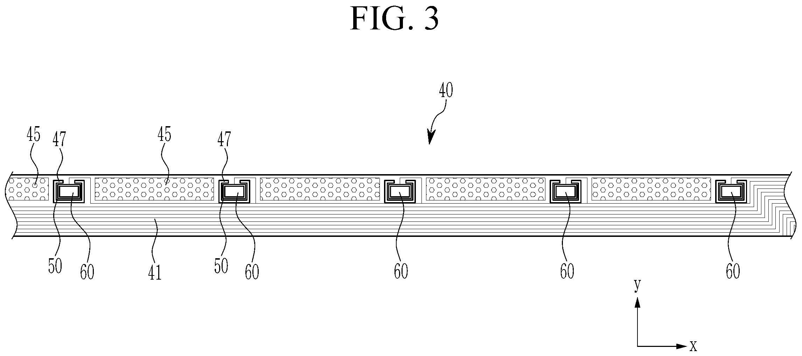

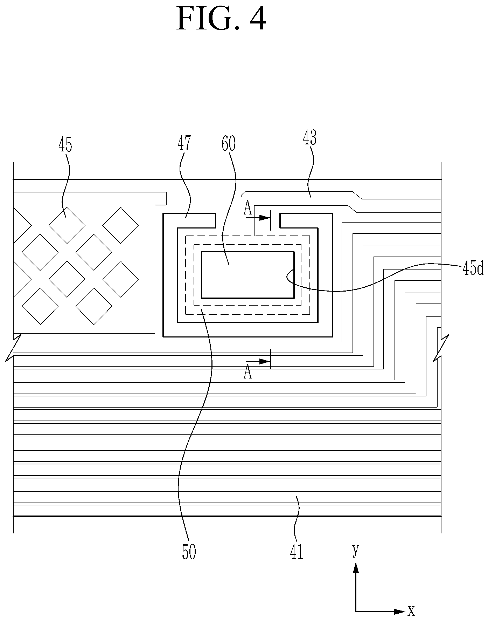

FIG. 3 is a top plan view schematically illustrating a flexible printed circuit according to a first embodiment. FIG. 4 is a top plan view schematically illustrating a copper thin film portion and a metal tab inserted into the flexible printed circuit of FIG. 3.

Referring to FIG. 3 and FIG. 4, in more detail, the flexible printed circuit 40 may include a signal line 41 configured to transmit a sensing signal, a connection line 43 configured to connect the copper thin film portion 50 to the signal line 41, and a covering portion 45 configured to: at least partially cover the signal line 41, the copper thin film portion 50, and the connection line 43; expose a portion of the copper thin film portion 50 in the first direction on a first side; and expose a portion of the metal tab 60 on a second side.

The signal line 41 is formed on a first side of the flexible printed circuit 40 in a width direction (y-axis direction), and extends in a length direction of the flexible printed circuit 40.

The connection line 43 may connect the copper thin film portion 50 to the signal line 41.

The copper thin film portion 50 is electrically connected to the busbar 30 by welding, and may be configured to detect connection of the battery cell 10 to the busbar 30 via insertion of the copper thin film portion 50 into an interior of the flexible printed circuit 40 and transfer the detection signal to the connection line 43 and the signal line 41.

The copper thin film portion 50 may be inserted into the interior of the flexible printed circuit 40 such that a portion of the copper thin film portion 50 may be exposed in a lower portion of the covering portion 45 when the copper thing film portion 50 is inserted into an interior of the covering portion 45 of the flexible printed circuit 40.

The thickness of the copper thin film portion (e.g., copper foil) 50 may be 35 µm, which is referred to as a 1 oz thickness. (One ounce of copper is 1.37 mils (0.00137 in) or 34.798 µm (0.034798 mm), i.e. 35 µm) thick when it is pressed flat and spread evenly over one square foot). A copper thin film portion of 1 oz or more rapidly increases the cost of the flexible printed circuit 40, and is not widely used.

The copper thin film portion 50 has excellent welding characteristics when the thickness is at least 100 µm, but when the thickness of the copper thin film portion is less than 100 µm, typically welding strength is deteriorated and laser welding becomes difficult. The present embodiment may enable stable welding strength even in the flexible printed circuit 40 using the copper thin film portion 50 that is 35 µm thick.

As for the copper thin film portion 50, a portion of a first side surface of the copper thin film portion 50 is exposed to the outside through a first exposure hole 45c formed on the first side of the flexible printed circuit 40, and a second side surface of the copper thin film portion 50 is exposed to the outside through a second exposure hole 45d formed on the flexible printed circuit 40. The metal tab 60 may be electrically connected to a surface, as explained in more detail when describing the covering portion 45.

The covering portion 45 may include a first covering layer 45a and a second covering layer 45b that cover the copper thin film portion 50 and the metal tab 60 when the copper thin film portion is positioned in the flexible printed circuit 40. As an example, the covering portion 45 may be formed of polyimide and coated with an adhesive 46.

That is, an adhesive may be applied on an inner surface of each of the first covering layer 45a and the second covering layer 45b so as to fix the copper thin film portion 50 and the metal tab 60 to a position between first/second covering layer 45a and 45b.

A slot hole 47 may surround an outer perimeter of the copper thin film portion 50 and penetrate the covering portion 45, and may have both ends formed at both sides of the connection line 43 in the width direction.

The first covering layer 45a forms the first side surface of the flexible printed circuit 40, and the first exposure hole 45c may be formed to expose the copper thin film portion 50 in the direction toward the busbar 30, which is the first direction.

The first exposure hole 45c may be in a polygonal shape, a round shape, or the like, and may be formed such that a portion of the surface of the copper thin film portion 50 may be exposed on the first side of the flexible printed circuit 40 via the first exposure hole 45c. Therefore, the busbar 30 may be electrically connected to the copper thin film portion 50 through the first exposure hole 45c.

The second covering layer 45b may form a second side surface of the flexible printed circuit 40 at a position facing the first covering layer 45a.

The second exposure hole 45d may be formed in the second covering layer 45b at a position corresponding to the first exposure hole 45c formed on the first covering layer 45a.

The second exposure hole 45d may be in a polygonal shape, a round shape, or the like, and may be formed such that a portion of the surface of the copper thin film portion 50 may be exposed on the second side of the flexible printed circuit 40 via the second exposure hole 45d.

Therefore, a portion of the metal tab 60 inserted between the first covering layer 45a and the second covering layer 45b may be exposed to the outside through the second exposure hole 45d.

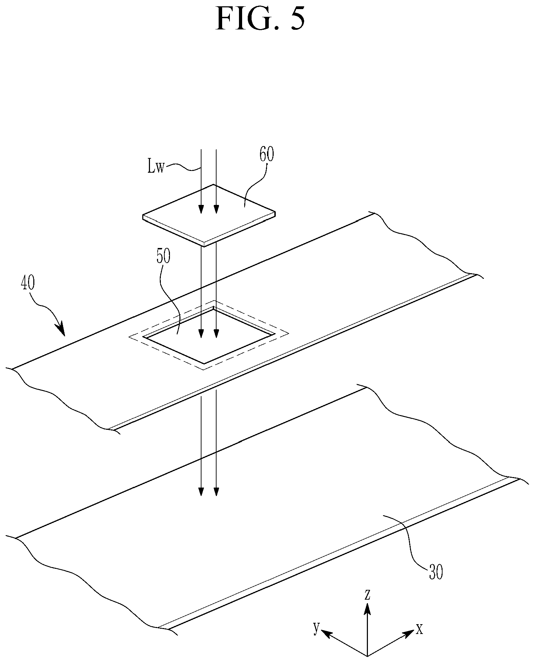

FIG. 5 is an exploded perspective view schematically illustrating a flexible printed circuit that mounts the copper thin film portion and a metal tab, the flexible printed circuit being laser-welded to a busbar. FIG. 6 is a cross-sectional view taken along line A-A of the flexible printed circuit of FIG. 4 where the copper thin film portion and a metal tab are inserted in the flexible printed circuit, the flexible printed circuit being laser-welded to a busbar.

As shown in FIG. 5 and FIG. 6, the metal tab 60 may be electrically connected to the copper thin film portion 50 when the copper thin film portion 50 is laser welded to the busbar 30, and the copper thin film portion 50 is disposed between the first covering layer 45a and the second covering layer 45b.

That is, the metal tab 60 is positioned on the surface of the copper thin film portion 50 without being electrically connected initially, and the flexible printed circuit 40 may be positioned in an upper portion of the busbar 30 such that the metal tab 60 may be electrically connected together with the copper thin film portion 50 when the copper thin film portion 50 is sandwich laser-welded to the busbar 30.

The metal tab 60 may be formed of, for example, aluminum, nickel, or copper material, as a metallic material that is easily electrically connected to the copper thin film portion 50. In the illustrated embodiments, the metal tab 60 is formed of an aluminum material, but is not necessarily limited thereto, and may be changed to a nickel or copper material.

The metal tab 60 may be formed in a thickness of 0.1-0.2 mm, in some embodiments.

Here, when a thickness of the metal tab 60 is less than 0.1 mm, an appropriate strength of a portion welded to the copper thin film portion 50 is difficult to achieve, thereby deteriorating the welding quality.

In addition, when the thickness of the metal tab 60 is greater than 0.2 mm, in the stacking process of the covering portion 45 including the first covering layer 45a and the second covering layer 45b, a lifting phenomenon due to pores may occur thereby deteriorating manufacturing quality.

Meanwhile, the copper thin film portion 50 may be positioned in a first area sized between the first covering layer 45a and the second covering layer 45b.

The copper thin film portion 50 may be exposed by the first exposure hole 45c and the second exposure hole 45d on both sides surface facing each other, while both side edge portions of the copper thin film portion 50 are covered by the first covering layer 45a and the second covering layer 45b.

In addition, as for the metal tab 60, a first surface is disposed on the surface of the copper thin film portion 50, and a portion of a second surface may be exposed by the second exposure hole 45d of the second covering layer 45b. The metal tab 60 may be formed with a second area size that is smaller than a first area of the copper thin film portion 50.

The metal tab 60 may have a lower surface electrically connected to an upper surface of the copper thin film portion 50, and both side edges of the metal tab 60 may be covered by the covering portion 45. To this end, a stepped portion 45e may be formed on an inner surface of a second penetration hole 45d of the second covering layer 45b.

The stepped portion 45e may be formed in a groove shape recessed into an inner surface in the direction of the second penetration hole 45d of the second covering layer 45b. The stepped portion 45e may be formed along a circumference of an inner wall surface of the second penetration hole 45d such that the entire edge portion of the metal tab 60 may be inserted therein.

Therefore, the metal tab 60 is electrically connected to the copper thin film portion 50 in a state that the edge portion of the metal tab 60 is positioned in the stepped portion 45e of the second covering layer 45b forming the covering portion 45, and a more stable electrical connection may be achieved when the metal tab 60 is inserted into the interior of the covering portion 45.

That is, in the interior of the covering portion 45,a first side surface of the metal tab 60 is electrically connected to the copper thin film portion 50, and a portion of a second side surface of the metal tab 60 may be exposed to the outside through the second penetration hole 45d of the second covering layer 45b.

As described above, according to the rechargeable battery module 100 of the present embodiment, when the metal tab 60 is inserted into an interior of the covering portion 45 and disposed on the surface of the copper thin film portion 50, it is possible to electrically connect the metal tab 60 to the busbar 30 by sandwich welding. Therefore, according to the present embodiment, during the process of manufacturing a flexible printed circuit 40, conventional soldering processes for connecting a metal tab to a busbar may not be needed, thereby enabling streamlining of the manufacturing process and reduction of manufacturing costs.

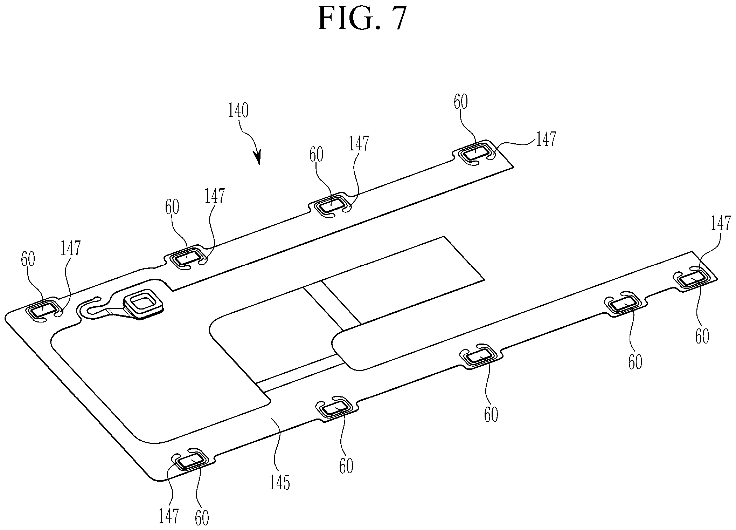

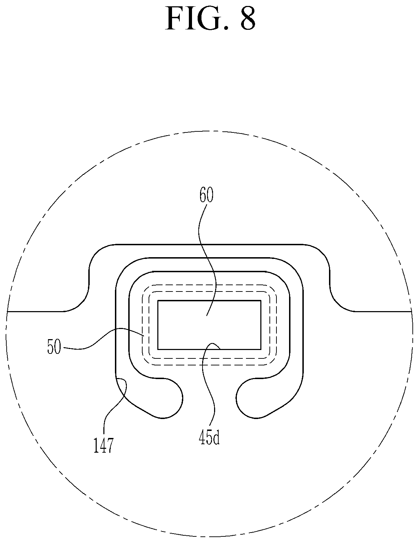

FIG. 7 is a drawing schematically illustrating a flexible printed circuit according to a second embodiment. FIG. 8 is a top plan view schematically illustrating the flexible printed circuit of FIG. 7 in which the copper thin film portion and a metal tab are inserted therein and electrically connected thereto. The same reference numerals as in FIG. 1 to FIG. 6 refer to identical or similar members with the same or similar functions in FIGS. 7-8. Hereinafter, detailed descriptions of the same reference numbers will be omitted.

As shown in FIG. 7 and FIG. 8, a flexible printed circuit 140 according to a second embodiment may include a covering portion 145 of a round shape curved in the length direction and a slot hole 147 of a tear drop shape formed along a circumference of the outer perimeter of the copper thin film portion 50.

The slot hole 147 may be formed to surround the outer perimeter of the copper thin film portion 50 and penetrate the covering portion 145.

In some embodiments, there is provided a method of manufacturing the rechargeable battery module described herein. The method may comprise (a) stacking a plurality of battery cells in a first direction; (b) providing a busbar holder such that the busbar holder at least partially covers the battery cells while exposing electrode terminals of the battery cells; (c) connecting the electrode terminals of the battery cells via a busbar, the electrode terminals of the battery cells being exposed through a busbar support portion of the busbar holder; (d) providing a flexible printed circuit (FPC) on and electrically connecting the flexible printed circuit to the busbar, the flexible printed circuit forming an exposure hole in a vertical direction perpendicular to the first direction and exposing a copper thin film portion of the flexible printed circuit in a direction toward the busbar; and inserting a metal tab into an interior of the flexible printed circuit and (e) electrically connecting the metal tab to a surface of the copper thin film portion, the metal tab being exposed outwardly through the exposure hole of the flexible printed circuit.

In some embodiments, the method further comprises applying an adhesive on an inner surface of each of the first covering layer and the second covering layer to fix the copper thin film portion and the metal tab to respective positions between the first and second covering layers.

In some embodiments, the method further comprises forming a slot hole at least partially surrounding a perimeter of the copper thin film portion and penetrating the covering portion, the slot hole having a first end and a second end, the first and second ends of the slot hole being disposed at respective sides of the connection line in a width direction.

According to some embodiments, there is provided a system for use in a rechargeable battery module described herein. The system may comprise one or more components described herein, including, for example a busbar and a flexible printed circuit (FPC) disposed on and electrically connected to the busbar. As described herein, the flexible printed circuit may comprise an exposure hole formed in the flexible printed circuit in a vertical direction; a copper thin film portion, the copper thin film portion being exposed in a direction towards the busbar; and a metal tab inserted into an interior of the flexible printed circuit, the metal tab being electrically connected to a surface of the copper thin film portion and exposed outwardly through the exposure hole.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

**<Description of symbols>**

| | | | |
|---|---|---|---|
| 10: | battery cell | 11, 12: | electrode terminal |
| 13: | vent | 20: | busbar holder |
| 21: | busbar support portion | 22: | vent portion |
| 30: | busbar | 40, 140: | flexible printed circuit |
| 41: | signal line | 43: | connection line |
| 45, 145: | covering portion | 45a: | first covering layer |
| 45b: | second covering layer | 45c: | first exposure hole |
| 45d: | second exposure hole | 45e: | stepped portion |
| 46: | adhesive | 47, 147: | slot hole |
| 50: | copper thin film portion | 60: | metal tab |
| 100: | rechargeable battery module | | |

## Claims

1. A rechargeable battery module, comprising:
a plurality of battery cells stacked in a first direction;
a busbar holder at least partially covering the battery cells while exposing electrode terminals of the battery cells;
a busbar connecting the electrode terminals of the battery cells exposed through a busbar support portion of the busbar holder;
a flexible printed circuit (FPC) forming an exposure hole in a vertical direction perpendicular to the first direction, the flexible printed circuit being disposed on and electrically connected to the busbar to expose a copper thin film portion of the flexible printed circuit in a direction toward the busbar; and
a metal tab inserted into an interior of the flexible printed circuit, the metal tab being electrically connected to a surface of the copper thin film portion, and exposed outwardly through the exposure hole.

2. The rechargeable battery module of claim 1, wherein the copper thin film portion is formed in a thickness of 1 oz.

3. The rechargeable battery module of claim 1 or claim 2, wherein the metal tab is formed in a thickness of 0.1-0.2 mm.

4. The rechargeable battery module of any one of the preceding claims, wherein the flexible printed circuit comprises:
a signal line configured to transmit a sensing signal;
a connection line configured to connect the copper thin film portion to the signal line; and
a covering portion configured to:
at least partially cover the signal line, the copper thin film portion, and the connection line;
expose a portion of the copper thin film portion on a first side of the copper thin film portion; and
expose a portion of the metal tab on a second side of the metal tab.

5. The rechargeable battery module of claim 4, wherein the covering portion comprises:
a first covering layer form ing a first exposure hole that exposes the copper thin film portion in the direction toward the busbar; and
a second covering layer, wherein the copper thin film portion and the metal tab are interposed between the first covering layer and the second covering layer, and the second covering layer forming a second exposure hole exposing a portion of the metal tab, and optionally wherein an adhesive is applied on an inner surface of each of the first covering layer and the second covering layer, so as to fix the copper thin film portion and the metal tab to a position between the first and second covering layers.

6. The rechargeable battery module of claim 5, comprising:
a slot hole configured to at least partially surround an outer perimeter of the copper thin film portion and penetrate the covering portion, the slot hole having a first end and a second end, the first and second ends of the slot hole being disposed at respective sides of the connection line in a width direction, and optionally wherein the signal line is formed on a first side of the flexible printed circuit in width direction, and extends in a length direction of the flexible printed circuit.

7. The rechargeable battery module of claim 6, wherein the copper thin film portion is inserted between the first covering layer and the second covering layer, and a portion of a surface on a first side of the copper thin film portion is exposed through the first exposure hole and a portion of a surface on a second side of the copper thin film portion faces the second exposure hole and is electrically connected to the metal tab, and optionally wherein the metal tab, the copper thin film portion, and the busbar are electrically connected to each other by welding when in surface contact with each other.

8. The rechargeable battery module of claim 7, wherein:
the copper thin film portion is inserted in a first area sized between the first covering layer and the second covering layer; and
the metal tab has a first surface electrically connected to the surface on the second side of the copper thin film portion and a second surface of which a portion is exposed by the second exposure hole of the second covering layer, and optionally wherein the second covering layer comprises a stepped portion having an edge portion of the metal tab located thereon, the stepped portion being formed on an inner surface of the second exposure hole of the second covering layer.

9. A method of manufacturing a rechargeable battery module, comprising:
stacking a plurality of battery cells in a first direction;
providing a busbar holder such that the busbar holder at least partially covers the battery cells while exposing electrode terminals of the battery cells;
connecting the electrode terminals of the battery cells via a busbar, the electrode terminals of the battery cells being exposed through a busbar support portion of the busbar holder;
providing a flexible printed circuit (FPC) on and electrically connecting the flexible printed circuit to the busbar, the flexible printed circuit forming an exposure hole in a vertical direction perpendicular to the first direction and exposing a copper thin film portion of the flexible printed circuit in a direction toward the busbar; and
inserting a metal tab into an interior of the flexible printed circuit and electrically connecting the metal tab to a surface of the copper thin film portion, the metal tab being exposed outwardly through the exposure hole of the flexible printed circuit.

10. The method of claim 9, wherein the copper thin film portion has a thickness of 1 oz.

11. The method of claim 9 or claim 10, wherein the metal tab has a thickness of 0.1-0.2 mm.

12. The method of any one of claims 9 to 11, wherein the flexible printed circuit comprises:
a signal line configured to transmit a sensing signal;
a connection line configured to connect the copper thin film portion to the signal line; and
a covering portion configured to:
at least partially cover the signal line, the copper thin film portion, and the connection line;
expose a portion of the copper thin film portion on a first side of the copper thin film portion; and
expose a portion of the metal tab on a second side of the metal tab.

13. The method of claim 12, wherein the covering portion comprises:
a first covering layer forming a first exposure hole that exposes the copper thin film portion in the direction toward the busbar; and
a second covering layer, wherein the copper thin film portion and the metal tab are interposed between the first covering layer and the second covering layer, and the second covering layer forming a second exposure hole exposing a portion of the metal tab, and optionally further comprising applying an adhesive on an inner surface of each of the first covering layer and the second covering layer to fix the copper thin film portion and the metal tab to a position between the first and second covering layers.

14. The method of claim 13, further comprising forming a slot hole at least partially surrounding a perimeter of the copper thin film portion and penetrating the covering portion, the slot hole having a first end and a second end, the first and second ends of the slot hole being disposed at respective sides of the connection line in a width direction.

15. A system for use in a rechargeable battery module, the system comprising:
a busbar; and
flexible printed circuit (FPC) disposed on and electrically connected to the busbar, the flexible printed circuit comprising:
an exposure hole formed in the flexible printed circuit in a vertical direction;
a copper thin film portion, the copper thin film portion being exposed in a direction towards the busbar; and
a metal tab inserted into an interior of the flexible printed circuit, the metal tab being electrically connected to a surface of the copper thin film portion and exposed outwardly through the exposure hole.
